# EUROPEAN PATENT APPLICATION

(11) **EP 1 906 256 A1**
(43) Date of publication of application: **02.04.2008**
(21) Application number: 06020706.5
(22) Date of filing: 02.10.2006
(51) Int. Cl.: G03F 7/20

(54) **Watermark defect reduction in immersion lithographic processing by resist optimisation**

(30) Priority: 27.09.2006 GB 0619041
(71) Applicant: Interuniversitair Microelektronica Centrum, 3001 Leuven (BE); Intel Corporation, Santa Clara, CA 95052-8119 (US)
(72) Inventor: Kocsis, Michael, Santa Clara, CA 95054 (US); Gronheid, Roel, 3370 Boutersem (BE); Soyano, Akimasa, 4870032 Kasugai-chi, Aichi (JP)
(74) Representative: Bird, Ariane

(57) **Abstract**

A method is described for lithographic processing. The method comprises obtaining a resist material (250) with predetermined resist properties, using said resist material (250) for providing a resist layer (4) on the device to be lithographic processed, and illuminating said resist layer (4) according to a predetermined pattern to be obtained. The obtained resist material (250) thereby comprises a tuned photo-acid generator component (254) and/or a tuned quencher component (256) and/or a tuned acid mobility as to reduce watermark defects on said lithographic processed device. The present invention also relates to a corresponding resist material (250), a set of resist materials, use of such materials and a method for setting up a lithographic process.

## Description

### Technical field of the invention

The present invention relates to the field of lithographic processing of devices, e.g. in semiconductor processing. More particularly, the present invention relates to systems and methods for immersion lithographic processing.

### Background of the invention

In the production of today's integrated circuits, optical lithography is one of the key techniques. The ongoing miniaturisation of integrated circuits or other devices results in a number of problems, which may be encountered during optical lithography. When, in an optical lithographic system, light generated by a light source is incident on a mask, the light will be diffracted. The smaller the dimensions of the structures on this mask, the more the light will spread. Hence, the smaller the dimensions of the structures on the mask, the less of this spread-out light will be collected by an objective lens so as to be focused onto a resist layer. As a result, the image of the mask structure formed onto the resist layer will be of a low quality. A well-known solution to cope with the light spreading and consequently to obtain sufficient quality of the mask image is the use of systems having a high numerical aperture (NA). Typically immersion fluids are used to deal with the corresponding incidence of light having a high angle of incidence onto the wafer.

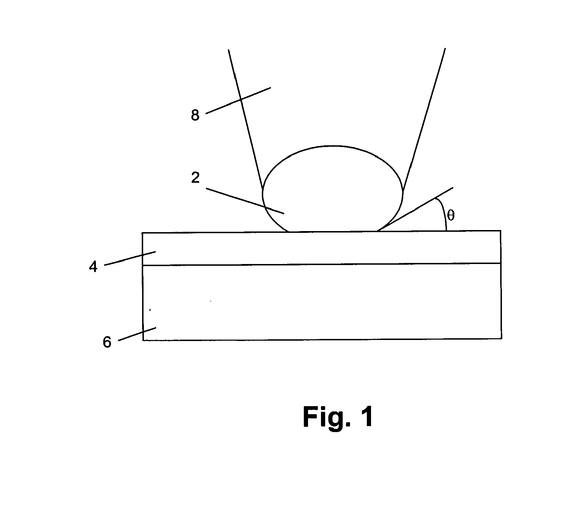

Implementing immersion lithography has given rise to a number of particular problems, for example associated with the use of an immersion fluid in contact with the resist layer used in the lithographic process. One of the problems arising is the presence of watermark defects on the lithographic processed devices. Watermark defects occur when water droplets, e.g. released by the nozzle of an immersion hood, remain on the device to be processed, dry on the surface and leave a residue of dissolved components. Water drops may be left on the surface e.g. when the receding contact angle between the immersion fluid and the substrate surface is too small. The receding contact angle θ between the immersion fluid 2 and the resist or resist stack 4 on the substrate 6 is shown in Fig. 1. Furthermore, the immersion hood 8 also is illustrated. Typically, such defects can affect the development process, resulting in bridging or T-topping defects occurring in circular patterns. Watermark defects typically have a diameter in the range of 1 µm to 5 µm, thus resulting in a high defect ratio. The occurrence of a watermark defect therefore may results in a non-useful die on the substrate.

One known technique for reducing or preventing watermark defects is the increase of the receding contact angle between the immersion hood and the resist. The receding contact angle can be altered e.g. by adjusting the hydrophobic character of the surface of the resist or top layer thereon, by adjusting the scanning speed, the type of showerhead, etc. Illustrations thereof are described e.g. Streefkerk B. et al., Proceedings of SPIE 6154 (2006) and in Kocsis M. et al., Proceedings of SPIE 6154 (2006). An alternative method for reducing or preventing watermarks is described by Kusumoto S. et al. in Polym. Adv. Technol. 17 (2006) 122. The document describes the use of topcoats that are not porous to water. The effect of rinsing on watermark defects also has been studied. The above solutions introduce limitations for the resist or resist stacks used, e.g. with respect to their wettability, and/or to the lithographic system used, e.g. with respect to the shape and scanning speed of the immersion hood.

### Summary of the invention

It is an object of the present invention to provide good methods for immersion lithographic processing and appropriate materials for obtaining good immersion lithographic processing. It is an advantage of embodiments of the present invention that resist materials and use of such materials in lithographic processes are provide resulting in a reduction of watermark defects. The reduction of watermark defects thereby may be both reduction in intensity, e.g. resulting in reduction in capacity to destroy dies made using the lithographic processing, as reduction in number of watermark defects.

The above objective is accomplished by a method and device according to the present invention.

The present invention relates to a resist material for use in immersion lithographic processing of a device, the resist material comprising a tuned photo-acid generator component and/or a tuned quencher component and/or a tuned acid mobility as to reduce watermark defects on the device after immersion lithographic processing using the resist material.

It is an advantage of embodiments according to the present invention that easy accessible parameters can be used for tuning resist properties in order to reduce watermark defects. It is furthermore an advantage of such embodiments that optimisation of these parameters may be performed taking into account other lithographic processing criteria, such as e.g. obtainable resolution, example given obtainable process window and/or an obtainable critical dimension. Other parameters that may be taken into account are any of or a combination of MEEF, line-edge roughness, resolution, etc. MEEF thereby is the mask error enhancement factor. With MEEF is meant the incremental change in the final resist feature size per unit change in the corresponding mask feature size, where the mask dimension is scaled to wafer size by the reduction ratio of the imaging tool. Both the photo-acid generator and/or quencher composition as the concentration of one or each of the components may be tuned. The concentration of said photo-acid generator component may be tuned and/or wherein a concentration of said quencher component is tuned.

It is an advantage of such embodiments according to the present invention that tuning the concentration allows to optimise reduction of watermark defects referred to a standard loading, thus allowing reduction of watermark defects without the need to amend the lithographic processing tool or a component thereof.

The photo-acid generator component concentration and/or the quencher component concentration may be substantially larger than concentrations resulting in optimum process window with said immersion lithographic processing. Other parameters that may be taken into account are any of or a combination of MEEF, line-edge roughness, resolution, etc. MEEF thereby is the mask error enhancement factor. The photo-acid generator component concentration may be larger than 2 weight percent, e.g. larger than 3 weight percent.

The photo-acid generator component concentration may for example be larger than 6 weight percent, or larger than 9 weight percent, or larger than 12 weight percent. The maximum concentration of the photo-acid generator component thereby is limited by 20 weight percent.

The quencher component concentration may be larger than 15 mol percent (with respect to PAG loading).

The quencher component concentration may for example be at least 30 mol percent, or at least 60 mol percent, or at least 90 weight percent.

The resist material may comprise deprotecting groups having a tuned activation energy.

The resist material may comprise polymer based resin having a tuned glass transition temperature.

The present invention also relates to the use of a resist material as described above for reducing the sensitivity to watermark defects in immersion lithographic processing.

The present invention also relates to a set of resist materials for use in lithographic processing of a device, each of said resist materials being a resist material having a different tuned photo-acid generator component and/or a different tuned quencher component and/or a different tuned acid modibility.

At least one resist material may be as described above.

The present invention also relates to the use of a set of resist materials as described above for reducing the sensitivity to watermark defects in immersion lithographic processing.

The present invention also relates to a method for setting up a lithographic processing of a device, the method comprising
tuning a resist material by tuning a photo-acid generator component and/or a quencher component and/or an acid mobility in the resist material as to reduce the sensitivity to watermark defects on said lithographic processed device thus obtaining a tuned resist material.

Tuning a photo-acid generator component and/or a quencher component may comprise selecting the photo-acid generator component concentration and/or the quencher component concentration is substantially larger than concentrations resulting in optimum process window with said immersion lithographic processing.

Tuning the photo-acid generator component concentration may comprise selecting a photo-acid generator component concentration larger than 2 weight percent, e.g. larger than 3 weight percent.

In the summary : the photo-acid generator component concentration may for example be larger than 6 weight percent, or larger than 9 weight percent, or larger than 12 weight percent. The maximum concentration of the photo-acid generator may be 20 weight percent.

Tuning the quencher component concentration may comprise selecting a quencher component concentration larger than 15 mol %.

The quencher component concentration may for example be at least 30 mol percent, or at least 60 mol percent, or at least 90 weight percent.

The present invention also relates to a method for lithographic processing of a device, the method comprising obtaining a resist material with predetermined resist properties, using said resist material for providing a resist layer on the device to be lithographic processed, and illuminating said resist layer according to a predetermined pattern to be obtained, said resist material comprising a tuned photo-acid generator component and/or a tuned quencher component and/or a tuned acid mobility as to reduce watermark defects on said lithographic processed device.

Obtaining a resist material with predetermined resist properties may comprise obtaining said resist material taking into account lithographic processing parameters relating to any of a dose or process window to be obtained with the lithographic process.

Obtaining a resist material with predetermined resist properties may comprise selecting a resist material from a set of resist materials.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved lithographic methods and systems allowing lithographic processing of devices, e.g. electronic devices with a higher yield.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a schematic illustration of an immersion hood allowing immersion lithographic processing of a device, as known from prior art.
Fig. 2 is a schematic representation of an immersion lithographic system as can be used in embodiments according to the present invention.
Fig. 3 is a schematic representation of part of a lithographic set-up according to an embodiment of the present invention.
Fig. 4 is an image of a watermark defect as can be controlled according to embodiments of the present invention.
Fig. 5a to Fig. 5c are images of watermark defects for different photo-acid generator concentrations in the resist being 3 weight percent (Fig. 5a), 6 weight percent (Fig. 5b) and 9 weight percent (Fig. 5c), as illustration of an embodiment according to the present invention.
Fig. 6a to Fig. 6c are images of watermark defects for different types of photo-acid generator (TPST in Fig. 6a, TPSN in Fig. 6b, TPSO in Fig. 6c), as illustration of an embodiment according to the present invention.
Fig. 7a to Fig. 7c are images of watermark defects for different quencher concentrations in the resist being 15 mol percent (Fig. 7a), 30 mol percent (Fig. 7b) and 60 mol percent (Fig. 7c), as illustration of an embodiment according to the present invention.
Fig. 8a to Fig. 8b are images of watermark defects for different photo-acid generator (PAG) concentrations and different quencher concentrations with a fixed PAG/quencher ratio, the PAG concentration in the resist being 3 weight percent (Fig. 8a) and 6 weight percent (Fig. 8b), as illustration of an embodiment according to the present invention.
Fig. 9a to Fig. 9d are images of watermark defects for different post-exposure bake temperatures being 100°C (Fig. 9a), 105°C (Fig. 9b), 110°C (Fig. 9c) and 110°C (Fig. 9d), as illustration of an embodiment according to the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments. Various features may be grouped in a single embodiment, figure or description. However, is not to be interpreted as reflecting an intention that the claimed invention requires more features than are expressly recited in each claim. The claims following the detailed description are hereby expressly incorporated into this detailed description, with each claim standing on its own as a separate embodiment of this invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention. In embodiments of the present application, the term "substrate" may include not only the basic carrier material but also materials to be processed and typical materials applied for performing a lithographic processing step, such as for example - but not limited to - a bottom anti-reflective coating. The term "substrate" furthermore also may include other materials, such as e.g. other materials used in semiconductor processing. The basic carrier material may be for example doped or undoped silicon, silicon-on-insulator substrate (SOI), gallium arsenide (GaAs), gallium arsenide phosphide (GaAsP), indium phosphide (InP), germanium (Ge), or silicon germanium (SiGe), glass or quartz substrates.

Where in the present application reference is made to "light" or "radiation", electromagnetic radiation typically used in immersion lithographic systems is referred to. In present application, often electromagnetic radiation having a wavelength of 193nm is used, but the invention is not limited thereto and other wavelengths in the ultraviolet and/or deep ultraviolet range or even other types of electromagnetic radiation may be used.

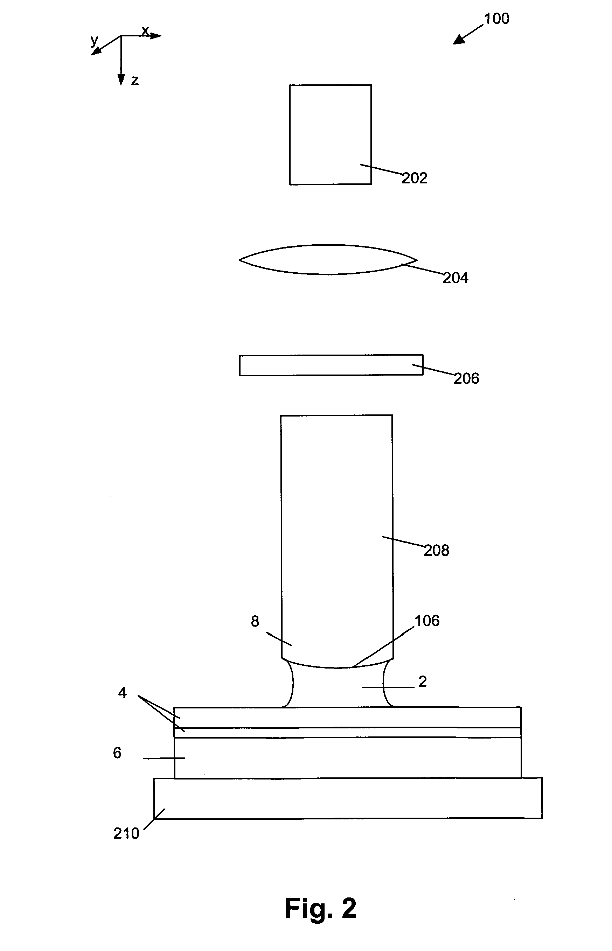

The embodiments of the present invention typically may be related to an immersion lithographic processing system. The method is applicable to lithographic processing which can be performed on any type of immersion lithographic set-up, such as but not limited to the set-up shown in Fig. 2, shown by way of illustration only. An optical lithographic system with a transmission set-up is shown, although the invention is not limited thereto and is e.g. also applicable to a system with a reflection set-up. It may be e.g. an immersion lithographic stepper system or an immersion lithographic scanner system. The optical immersion lithographic system 100 typically comprises a source of electromagnetic radiation, e.g. an irradiation source 202. The radiation from the irradiation source 202 typically is transmitted through an optical system 204 comprising a lens and is incident on a mask 206. The mask 206 contains information about the image to be generated in a resist layer or resist stack 4 and is basically defined thereby. Typically the mask 206 may be part of a set of masks used for creating a device or circuit using lithography. Different types of masks exist; such as e.g. an alternated phase shift mask, an attenuated phase shift mask, a binary mask, etc. The light, carrying the mask information, is then passed through an imaging module 208, which e.g. may have a final lens surface 106, and thus is guided to a resist layer or resist stack 4 on a substrate 6. The optics of the imaging module 208 inherently defines the numerical aperture (N.A.) of the imaging module 208. The device 102 typically is mounted on a substrate stage 210. Typically an immersion showerhead 8, also referred to as immersion hood 8, provides an immersion liquid 2 between the resist layer or resist stack 4 and the output of the imaging module 208, e.g. the final lens surface 106, in order to allow increase of the numerical aperture of the system 100. Other optional and/or additional components are not illustrated in Fig. 2. The system shown is only shown by way of illustration. For example, alternative systems that could be used are systems operating with micro-mirrors, e.g. systems used as optical mask writers.

The present invention will now further be described with respect to a number of different aspects and embodiments.

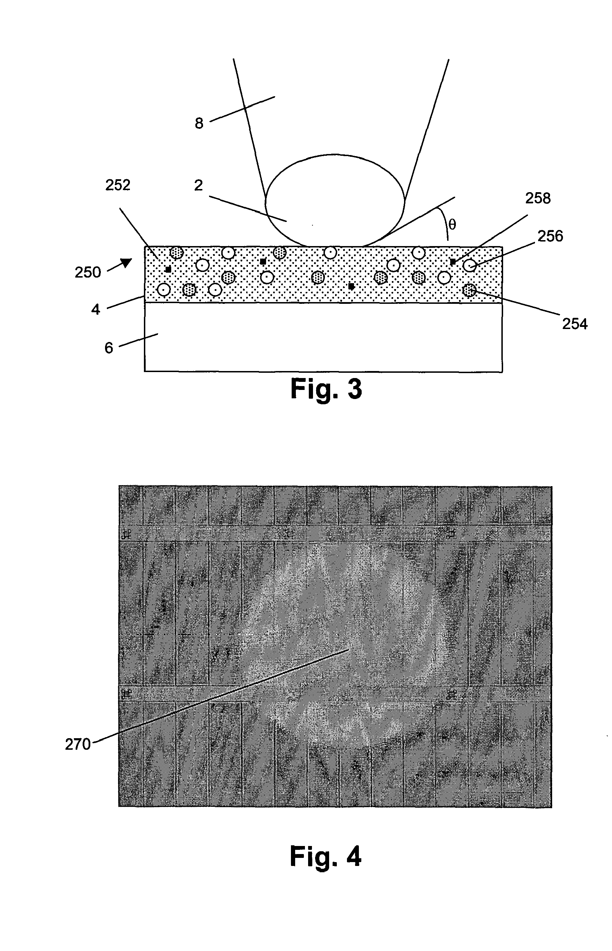

In a first aspect, the present invention relates to a method for immersion lithographic processing, wherein the number of watermark defects can be reduced or optionally even watermark defects can be avoided. Reduction of watermark defects thereby may refer to a reduction in size or intensity of the watermark defect(s) and/or to a reduction in number of watermark defects occurring on a substrate processed with immersion lithographic processing. The relative intensity of watermark defects may for example be determined by the total area of pattern damage by the watermark for various materials or process conditions when a water droplet of a fixed volume is deposited. A watermark defect stems from a liquid drop, often an immersion liquid drop, remaining on the surface of the device, e.g. during irradiation in the immersion lithographic processing, and interacting with the resist. In the present invention, reduction of watermark defects is obtained by adjusting the resist material used or selecting an adjusted resist material. The lithographic processing typically comprises obtaining a resist material having predetermined properties. Such a resist material 250 is used for providing a resist layer 4 on a device, e.g. substrate 6, to be lithographic processed, as indicated in Fig. 3. The resist material 250 preferably comprises a polymer base resin 252, a photo-acid generator (PAG) 254, a quencher 256 and a photoresist solvent 258, as indicated in Fig. 3. The resist material 250 may be any suitable type of resist material, such as e.g. positive resist material or a negative resist material. It may be a chemically amplified resist material. It may be an immersion lithographic specific resist material. Typical examples of resist materials that may be used, without limiting the invention thereto, are PAR-817 resist and PAR-IM850 resist as available from Sumitomo Inc. The polymer base resin 252 is the component remaining on the substrate after developing of the resist material. Typical examples of polymer base resins that may be used in resist materials may be methacrylate polymers (for ArF-type resists) which have protect groups and lactone groups, polymers based on acetoxystyrene monomers, etc.

The photo-acid generator component 254 provides acid component in the resist material 250 once the resist material is irradiated. This component converts the molecular structure of the polymer base resin 252, resulting in either a more easy or a more hard polymer structure to be removed during developing and etching. The quencher 256 provides the functionality of controlling the diffusion length of the acid generated by a photo-acid generator. The photoresist solvent 258 allows to control the viscosity of the photoresist material. The lithographic method also comprises irradiating the resist layer according to a predetermined pattern, based on the pattern to be generated in the device.

In the present invention, obtaining a resist material 250 comprises obtaining a resist material 250 whereby any of the photo-acid generator 254 and/or the quencher 256 and/or the acid mobility is tuned in order to reduce the watermark defects. In other words, in the present invention, the photo-acid generator 254 and/or the quencher 256 and/or the acid mobility of the resist layer are used as parameters for optimising the resist material such that the resulting immersion lithographic processing of a device is less sensitive to watermark defects. The resist material thus obtained comprises predetermined properties such that the resist material allows obtaining an immersion lithographic processing of a device which is less sensitive to watermark defects. In one embodiment, obtaining a resist material 250 comprises selecting a resist material from a number of predetermined resist materials, each of them having different resist properties, being a different photo-acid generator component or a different concentration thereof, a different quencher component or a different concentration thereof or a different acid mobility or a combination thereof. Such a selection also may be a selection from a set of resist materials 250, each having their predetermined resist properties being different from each other. Such a selection could e.g. be made as function of the particular lithographic settings for lithographic processing, i.e. for the resolution, i.e. the critical dimension, to be obtained or for the irradiation dose to be used. Such particular lithographic settings may be settings which are application specific, i.e. these may dependent e.g. on the pattern to be generated.

Selecting also may comprise a simulation step or computing step for determining the allowable resist adjustment as function of other lithographic processing parameters to be obtained. The latter may be done in an automated and/or automatic way. It may be performed according to a predetermined algorithm, based on trial and error, using a neural network, using reference simulation results or measurement results previously obtained or obtained at that moment, etc. Selection of an allowable sensitivity, i.e. selection of the degree of insensitivity to be obtained, optionally in combination with other lithographic processing requirements, may be performed with respect to a predetermined rule or requirement, e.g. the number of watermarks being lower than a predetermined value, the average diameter of the watermarks being lower than a predetermined value, etc. Selecting the resist to be used may comprise selecting a resist material from a set of resist materials, the selected resist material having resist properties being closest to the resist properties preferred in order to reduce sensitivity to watermark defects.

The method furthermore comprises providing a resist layer using the obtained resist material on a substrate and irradiating the resist layer according to a predetermined pattern. Providing the resist layer on the substrate may be performed in any suitable way, such as e.g. by spincoating, dipcoating, etc. Other optional steps for the lithographic processing may include baking steps, developing steps, etching steps, cleaning steps, etc. and are known in the art.

A number of parameters of the lithographic processing system or application are system and application specific and/or may be selected as function of their availability or their influence on the print to be obtained. By way of example, the present invention not being limited thereby, a set of possible parameters may be as follows :
The substrate used may be a bare silicon substrate (12inch) provided with an anti-reflective coating ARC29A as available from Brewer science. The resist film thickness may be 150nm. The resist film may be applied using a Tokyo-electron, CLEAN TRAC ACT12 system. The exposure tool is a ASML XT1250i lithographic system, with an illumination system with parameters NA=0.85, Annular(0.89/0.57). The reticle used is a binary reticle with 100nmL/S pattern to look for defectivity. The developer used is TMAH2.38wt%(23°C, 60sec) as available from LFCS Ltd. The critical dimension obtainable is characterised by Hitachi 9380II by Hitachi-high technology. The pattern size used is a 100nmL/200nmP top-down pattern. A stack of bare silicon, a bottom anti-reflective coating and a resist layer may be used wherein the bottom anti-reflective coating is applied under 205°C during 90s, the resist coating has occurred with a soft bake of 120°C during 60s. The tool used for checking the defectivity is a KLA2351 defectivity tool.

The present invention will now further be described by way of particular embodiments and examples, the invention not being limited thereto.

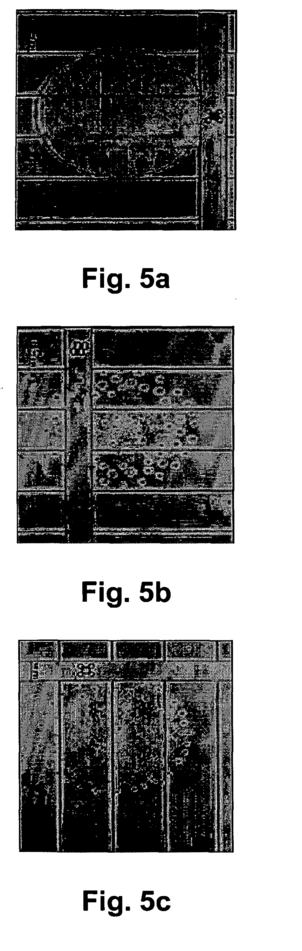

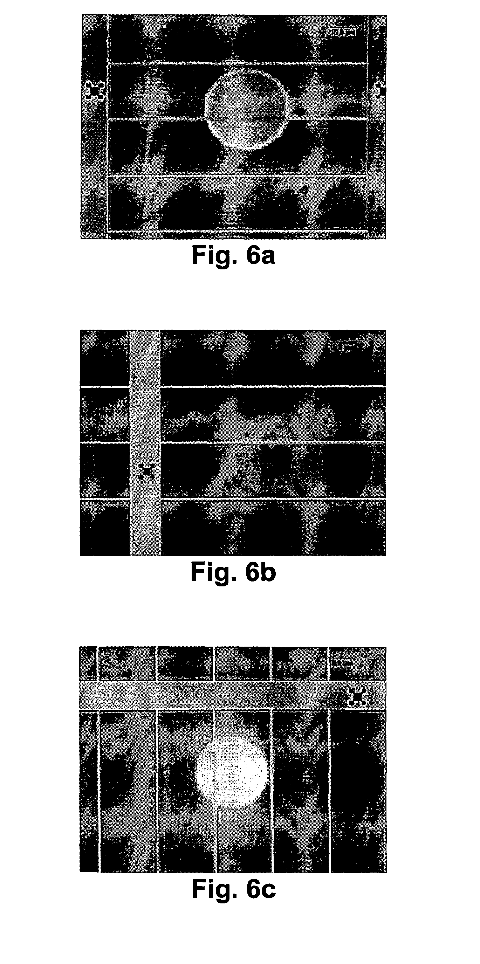

In a first particular embodiment, the present invention relates to a method for lithographic processing as described above, wherein obtaining a resist material comprises obtaining a resist material wherein the photo-acid component 254 is tuned for reducing sensitivity to watermark defects on a device after such lithographic processing. Tuning the photo-acid generator component 254 thereby may comprise both selection of a photo-acid component and/or selection of a concentration of photo-acid component 254. The tuning of the photo-acid generator may be resist-specific, i.e. may be specific to the component materials present in that resist. In one example, sensitivity to watermark defects of a corresponding lithographic process may be reduced by increasing the concentration of photo-acid component 254. The concentration may be increased with respect to a standard concentration of photo-acid generator component 254. Such a standard concentration may be different for different standard resist materials. It may e.g. be determined based on the maximum obtainable process window. It may e.g. be determined based on the optimum process window obtainable with said immersion lithographic processing, e.g. obtained without taking watermark defects into account. According to the present embodiment, the photo-acid concentration is selected higher than such standard concentration. The photo-acid generator component concentration may for example be larger than 3 weight percent or for example be larger than 5 weight percent, or larger than 7 weight percent, or larger than 10 weight percent. In principle the larger the photo-acid generator component, the better. The maximum concentration of the photo-acid generator component may be 15 weight percent or even 20 weight percent. Alternatively or in addition thereto, the photo-acid generator component 254 also may be tuned by altering the chemical composition of the photo-acid generator component. The photo-acid generator component may e.g. be selected from any of Triphenylsulfonium nonafluoro-n-butanesulfonate TPST, Triphenylsulfonium trifluoromethanesulfonate TPSN, Triphenylsulfonium perfluoro-n-octanesulfonate TPSO. By way of illustration, two examples of the effect of tuning the photo-acid generator are provided with reference to Figs. 5a to 5c and Figs. 6a to 6c. Figs. 5a to 5c illustrate the obtained results on watermark defects when the concentration of a photo-acid generator is altered in a resist material used for lithographic processing. The results are obtained for a model resist, based on a polymer as obtainable from JSR Corporation, a quencher as obtainable from JSR Corporation and propylene glycol monomethyl ether acetate solvent (PGMEA). wherein the concentration of the photo-acid generator 254 is varied from 3 weight percent, over 6 weight percent and 9 weight percent, to 12 weight percent. Fig. 5a indicates a watermark defect found at 3 weight percent, Fig. 5b indicates a watermark defect found at 6 weight percent and Fig. 5c indicates a watermark defect found at 9 weight percent. At 12 weight percent, no watermark defects were found anymore. The present example illustrates that by tuning the photo-acid generator 254 concentration, watermark defects can be reduced or even completely removed. By increasing the concentration of the photo-acid generator 254, the sensitivity to watermark defects, induced during the corresponding lithographic processing of the device, decreases. A second example is shown in Figs. 6a to 6c, wherein three different types of photo-acid generator 254 components are used, all resulting in a different sensitivity to watermark defects. Fig. 6a shows the result for a TPST photo-acid generator, Fig. 6b for a TPSN photo-acid generator and Fig. 6c for a TPSO photo-acid generator. Parameters whereon the photo-acid generator 254 may be selected are for example acid strength, molecule size, diffusion length, etc.

In a second particular embodiment, the present invention relates to a method for lithographic processing as described above, optionally also according to the first embodiment, wherein obtaining a resist material 250 comprises obtaining a resist material 250 with a quencher component 256 concentration tuned to reduce the sensitivity of the corresponding lithographic processing of a device to watermark defects. In the present embodiment, tuning the quencher component 256 concentration may depend on the other components present in the resist 250. Tuning the quencher component 256 may for example comprise increasing the quencher component 256 concentration with respect to a standard concentration of quencher component 256 present in the resist material 250. Often such a standard concentration may be in the range 0.25 to 1.5 weight percent per polymer.

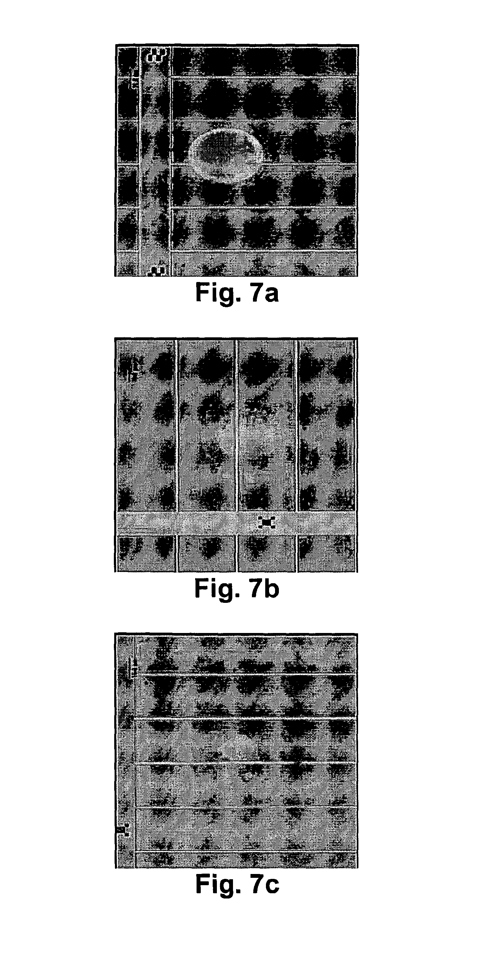

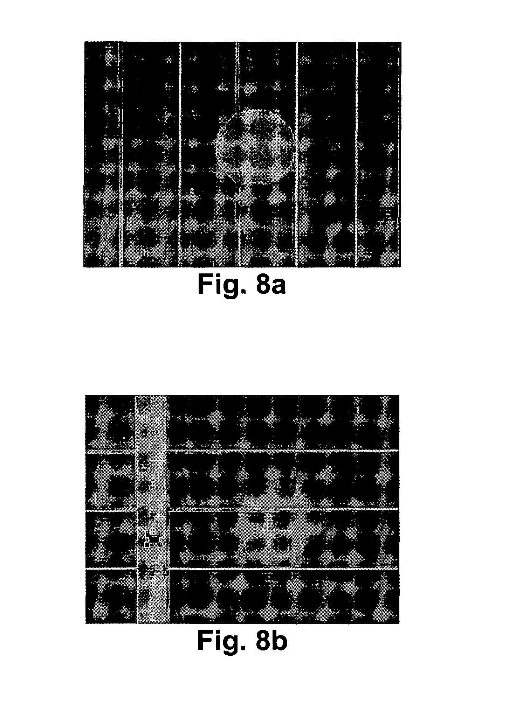

The standard concentration also may be determined based on the optimum process window obtainable with said immersion lithographic processing, e.g. obtained without taking watermark defects into account. Other parameters that may be taken into account are any of or a combination of MEEF, line-edge roughness, resolution, etc. MEEF thereby is the mask error enhancement factor. By way of example, the present invention not being limited thereto, an example of tuning of a model resist is shown in Fig. 7a, Fig. 7b and Fig. 7c, illustrating watermark defects at a quencher concentration of 15 mol percent, 30 mol percent and 60 mol percent. No watermark defects were found at a quencher component concentration of 90 mol percent. In the present example, the sensitivity to watermark defects decreases with increasing quencher component concentration. In a further example, as illustrated in Fig. 8a and Fig. 8b, the concentration of the quencher component 256 and the photo-acid generator component 254 are simultaneously tuned such that the ratio of the photo-acid generator component 254 to the quencher component 256 is constant. Results were obtained for photo-acid generator concentrations of 3 weight percent, 6 weight percent, 9 weight percent and 12 weight percent whereby the quencher component 256 was simultaneously altered such that a ratio of 0.2 weight/mol is obtained for the photo-acid generator / quencher ratio. Fig. 8a illustrates a watermark defect for devices obtained using a resist with photo-acid generator concentration of 3 weight percent and Fig. 8b illustrates a watermark defect for devices obtained using a resist with photo-acid generator concentration of 6 weight percent. For a photo-acid generator concentration of 9 weight percent and 12 weight percent no watermark defects could be distinguished anymore. In other words, increasing both the photo-acid generator concentration and the quencher component concentration also results in a reduced sensitivity to watermark defects.

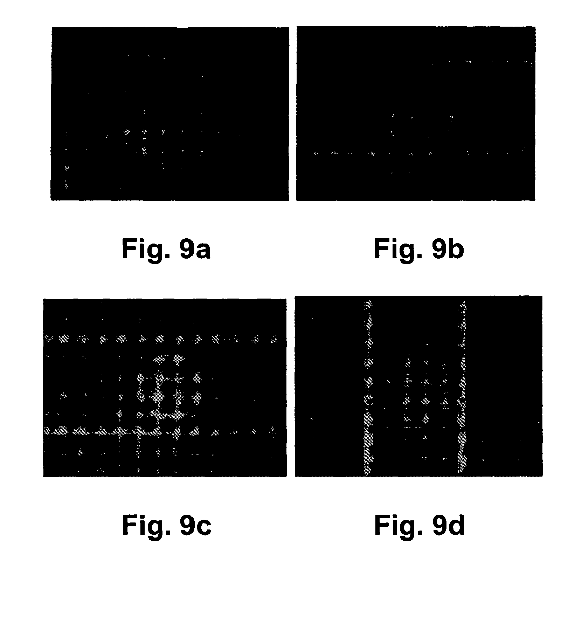

In a third particular embodiment, a method for lithographic processing according to the present invention as described above is disclosed, wherein the acid mobility in the resist material 250, or more particular a resist layer 4 made of said resist material 250, is tuned as to reduce the sensitivity to watermark defects in lithographic processing of devices using such resist material 250. Such a tuning of the acid mobility in the resist layer 4 can be obtained in a number of ways. One way of tuning the acid mobility in the resist material 250 is by controlling the temperature treatment required for using the resist material 250 in a lithographic process. For example, the temperature of the baking steps, e.g. the post-exposure bake step, can be controlled whereby a lower post-exposure bake temperature will lead to a lower acid mobility whereas a higher post-exposure bake temperature will lead to a higher acid mobility. The required temperatures can be tuned by using particular components in the resist. In this way, the acid mobility can be indirectly influenced by tuning a glass transition temperature of the polymer based resin 252 used. E.g. a lower glass transition temperature will result in a lower acid mobility as lower temperatures are needed for processing the polymer based resin 252 in the resist material 250, whereas a higher glass transition temperature will result in a higher acid mobility as higher temperatures will be needed for processing the polymer based resin 252 in the resist material 250. Alternative or in addition thereto, the activation energy of the deprotecting groups may be tuned. By tuning the activation energy, the temperatures needed for processing the resist material 250 will be different and consequently the acid mobility may be tuned. Another parameter that may be tuned in order to tune the acid mobility is the type of photo-acid generator 254 that is used. Selection may be made from a number of photo-acid generators such as Triphenylsulfonium nonafluoro-n-butanesulfonate TPST, Triphenylsulfonium trifluoromethanesulfonate TPSN, Triphenylsulfonium perfluoro-n-octanesulfonate TPSO. Tuning of the acid mobility may be more or less effective depending on the particular materials used as resist layer and e.g. depending on the presence of a top layer. In the following example an illustration is shown for the effect of post-exposure bake temperature on the sensitivity to watermark defects. The latter indirectly indicates the effect of acid mobility on the sensitivity to watermark defects. The results are shown in Fig. 9a to Fig. 9b, indicating watermarks occurring on the device for lithographic processing using a post bake exposure temperature of 100°C (Fig. 9a), 105°C (Fig. 9b), 100°C (Fig. 9c) and 115°C (Fig. 9d). It can be seen that in the present example a higher post exposure bake temperature results in less pronounced watermark defects. This result is obtained using lithographic processing parameters as given by way of example above. The reference glass transition temperature for the standard polymers used in resist typically vary between 150°C and 180°C. In a further particular embodiment, the present invention relates to a method for lithographic processing as described in the first aspect, wherein the method comprises obtaining lithographic parameters characterising the result of the print to be obtained and wherein obtaining a resist material comprises taking into account the lithographic parameters characterising the result of the print to be obtained. The latter may e.g. reduce the parameter range for which the resist properties can be tuned in view of reduction of watermarks. Alternatively or in addition thereto, the method may comprise tuning both resist parameters and lithographic processing parameters characteristic of the print to be obtained, thus obtaining lithographic processing parameters to be used and a resist material to be used.

In a second aspect, the present invention relates to a resist material 250 for use in lithographic processing, for example as described in the first aspect, wherein resist properties of the resist material 250 are tuned as to reduce watermark defects on the device after immersion lithographic processing using that resist material 250. The resist material 250 may comprise a tuned photo-acid generator component 254 and/or a tuned quencher component 256 and/or a tuned acid mobility. In other words, the photo-acid generator component 254, e.g. a concentration thereof, and/or the quencher component 256, e.g. a concentration thereof, and/or the degree of acid mobility are used as parameter to obtain a resist material 250 which, when used in lithographic processing of a device, results in reduced watermark defects on the device. The tuning may be selection of a concentration of the photo-acid generator 254 and/or selection of the quencher component concentration. The tuned components may be tuned such that a higher concentration of the photo-acid generator component 254 or a higher concentration of the quencher component 256 is obtained than a standard concentration. Such a standard concentration may be a concentration determined based on the optimal process window obtainable with the immersion lithographic process used. Other parameters that may be taken into account are any of or a combination of MEEF, line-edge roughness, resolution, etc. MEEF thereby is the mask error enhancement factor. The photo-acid generator component concentration may be larger than 2 weight percent, e.g. larger than 3 weight percent, e.g. larger than 6 weight percent, e.g. larger than 9 weight percent, e.g. larger than 12 weight percent. The maximum concentration thereby may be 20 weight percent.
The quencher concentration may be selected to be larger than 15 mol percent, e.g. larger than 30 mol percent, e.g. larger than 60 mol percent, e.g. larger than 90 mol percent. The maximum concentration thereby may be 2 weight percent. A lower limit for the concentration range of the quencher concentration may be 0.2 weight percent.

The acid mobility in the resist material 250, or more particularly in a layer made with such resist material 250, may also be controlled or tuned. A resist comprising a polymer material 252 with a tuned glass transition temperature may be selected. The glass transition temperature may be tuned such that the glass transition temperature is higher than the post-exposure bake temperature of the resist process.
The resist material 250 may comprise deprotecting groups wherein the activation energy is tuned.
Furthermore, the resist material 250 may comprise similar features and advantages as the resist properties described in the first aspect.

In a third aspect, the present invention relates to the use of a resist material 250 as described in the second aspect, for reducing the sensitivity to watermark defects in immersion lithographic processing of a device. The latter allows to obtain a higher yield of the lithographic processing method. Furthermore, it is an advantage of embodiments of using such a resist material for immersion lithographic processing as reduction of watermark defects can be obtained without the need for changes to the lithographic system used.

In a fourth aspect, the present invention relates to a set of resist materials 250, for immersion lithographic processing of a device, wherein the resist materials 250 have different resist properties. The different resist properties may be different photo-acid generator components 254 or a different photo-acid generator component concentrations and/or different quencher concentrations and/or different acid mobility properties of the resist material 250, or more particularly in the resulting resist layers made using the resist materials. Such a set of resist materials 250 may be used to select an appropriate resist material 250 depending on the allowed watermark sensitivity and/or depending on other requirements for the lithographic processing of the device. Selection of a resist material with predetermined properties may e.g. also be performed based on the process window to be obtained and the resulting critical dimension, the allowed and usable exposure dose, the exposure time, etc. Such a set of resist materials may be a set of resist materials, each resist material being as described in the second aspect, wherein other parameters of the lithographic process to be applied, e.g. relating to exposure parameters that may be pattern specific, are taken into account. The set of resist materials 250 preferably comprises a plurality of resist materials 250, labelled as to indicate lithographic processing conditions that can be obtained using the resist materials 250.

In a fifth aspect, the present invention relates to the use of such a set of resist materials 250 in lithographic processing of a device. Lithographic processing of a device thereby may comprise selecting one of resist material from the set of resist materials. Such a selection may be based on the required degree of sensitivity or insensitivity to watermark defects. Furthermore, e.g. in combination with sensitivity or insensitivity to watermark defects, selection of one resist material may be based on required lithographic processing goals or parameters, such as the process window required, dose and resulting critical dimension, for the particular application. Other parameters that may be taken into account are any of or a combination of MEEF, line-edge roughness, resolution, etc. MEEF thereby is the mask error enhancement factor.

It is an advantage of embodiments of the present invention that the acid concentration close to the resist surface can be controlled, even if immersion liquid remains on the surface of the resist, e.g. in the form of drops of immersion liquid left from the immersion hood.

It is to be understood that although preferred embodiments, specific constructions and configurations, as well as materials, have been discussed herein for devices according to the present invention, various changes or modifications in form and detail may be made without departing from the scope and spirit of this invention. For example, whereas the invention has been described by way of a (set of) resist(s), use thereof and a method for lithographic processing, the present invention also relates to a method for setting up lithographic processing, wherein the method comprises tuning a resist material by tuning a photo-acid generator component and/or a quencher component and/or an acid mobility in the resist material as to reduce the sensitivity to watermark defects on said lithographic processed device thus obtaining a tuned resist material. The tuning may be performed as described in the previous aspects of the present invention.

## Claims

1. A resist material (250) for use in immersion lithographic processing of a device, the resist material (250) comprising a tuned photo-acid generator component (254) and/or a tuned quencher component (256) and/or a tuned acid mobility as to reduce watermark defects on the device after immersion lithographic processing using the resist material (250).

2. A resist material (250) according to claim 1, wherein a concentration of said photo-acid generator component (254) is tuned and/or wherein a concentration of said quencher component (256) is tuned.

3. A resist material (250) according to claim 2, wherein the photo-acid generator component concentration and/or the quencher component concentration is substantially larger than concentrations resulting in optimum process window with said immersion lithographic processing.

4. A resist material (250) according to any of claims 2 to 3, wherein the photo-acid generator component concentration is larger than 2 weight percent.

5. A resist material (250) according to claim 4, wherein the photo-acid generator component concentration is larger than 3 weight percent.

6. A resist material (250) according to any of claims 2 to 5, wherein the photo-acid generator component concentration is smaller than 20 weight percent.

7. A resist material (250) according to any of claims 2 to 6, wherein the quencher component concentration is larger than 15 mol percent.

8. A resist material (250) according to any of claims 1 to 6, wherein the resist material (250) comprises deprotecting groups having a tuned activation energy.

9. A resist material (250) according to any of claims 1 to 7, wherein the resist material (250) comprises polymer based resin (252) having a tuned glass transition temperature.

10. Use of a resist material (250) according to any of claims 1 to 9 for reducing the sensitivity to watermark defects in immersion lithographic processing.

11. A set of resist materials (250) for use in lithographic processing of a device, each of said resist materials (250) being a resist material (250) having a different tuned photo-acid generator component (254) and/or a different tuned quencher component (256) and/or a different tuned acid mobility.

12. A set of resists materials (250) according to claim 11, at least one resist material (250) being according to any of claims 1 to 9.

13. Use of a set of resist materials (250) according to any of claims 11 to 12 for reducing the sensitivity to watermark defects in immersion lithographic processing.

14. A method for setting up a lithographic processing of a device, the method comprising
- tuning a resist material (250) by tuning a photo-acid generator component (254) and/or a quencher component (256) and/or an acid mobility in the resist material (250) as to reduce the sensitivity to watermark defects on said lithographic processed device thus obtaining a tuned resist material (250).

15. A method according to claim 14, wherein tuning a photo-acid generator component (254) and/or a quencher component (256) comprises selecting the photo-acid generator component concentration and/or the quencher component concentration is substantially larger than concentrations resulting in optimum process window with said immersion lithographic processing.

16. A method according to claim 15, wherein tuning the photo-acid generator component concentration comprising selecting a photo-acid generator component concentration larger than 3 weight percent.

17. A method according to any of claims 15 to 16, wherein tuning the quencher component concentration comprises selecting a quencher component concentration larger than 15 mol %.

18. A method for lithographic processing of a device, the method comprising
- obtaining a resist material (250) with predetermined resist properties,
- using said resist material (250) for providing a resist layer (4) on the device to be lithographic processed, and
- illuminating said resist layer (4) according to a predetermined pattern to be obtained,
said resist material (250) comprising a tuned photo-acid generator component (254) and/or a tuned quencher component (256) and/or a tuned acid mobility as to reduce watermark defects on said lithographic processed device.

19. A method according to claim 18, wherein obtaining a resist material (250) with predetermined resist properties comprises obtaining said resist material (250) taking into account lithographic processing parameters relating to any of a dose or process window to be obtained with the lithographic process.

20. A method according to any of claims 18 to 19, wherein obtaining a resist material (250) with predetermined resist properties comprises selecting a resist material (250) from a set of resist materials (250).
